# EUROPÄISCHE PATENTANMELDUNG

(11) **EP 4 009 357 A1**
(43) Veröffentlichungstag der Anmeldung: **08.06.2022**
(21) Anmeldenummer: 21212011.7
(22) Anmeldetag: 30.01.2017
(51) Int. Cl.: H01L 21/683, B24B 37/16, H01L 21/687, H01L 21/67, H01L 21/677

(54) **VAKUUMSPANNVORRICHTUNG ZUM AUFSPANNEN VON WERKSTÜCKEN, MESSVORRICHTUNGEN UND VERFAHREN ZUM PRÜFEN VON WERKSTÜCKEN, INSBESONDERE WAFERN**

(30) Priorität: 03.02.2016 DE 102016101842
(62) Teilanmeldung aus: 17153684.0
(71) Anmelder: Helmut Fischer GmbH Institut für Elektronik und Messtechnik., 71069 Sindelfingen (DE)
(72) Erfinder: VOLZ, Werner, 71069 Sindelfingen (DE); BOOS, Paul, 72411 Bodelshausen (DE)
(74) Vertreter: Patentanwälte Mammel und Maser PartG mbB

(57) **Zusammenfassung**

**Vakuumspannvorrichtung** zum Aufspannen von Werkstücken, Messvorrichtungen und Verfahren zum Prüfen von Werkstücken, insbesondere Wafern Die Erfindung betrifft eine Vakuumaufspannvorrichtung zum Aufspannen von Werkstücken (19), insbesondere Wafern, sowie eine Messvorrichtung und ein Verfahren zum Prüfen von Werkstücken, insbesondere Wafern, mittels Röntgenfluoreszenzstrahlung.

## Beschreibung

Die Erfindung betrifft eine Vakuumspannvorrichtung zum Aufspannen von Werkstücken, insbesondere von Wafern, sowie eine Messvorrichtung zum Prüfen von auf einer solchen Vakuumspannvorrichtung aufgespannten Werkstücken sowie ein Verfahren zum Prüfen eines auf der Vakuumspannvorrichtung aufgespannten Werkstücks.

Aus der WO 2014/188572 A1 ist eine Vakuumspannvorrichtung zum Aufspannen von Werkstücken bekannt. Diese Vakuumspannvorrichtung umfasst eine Auflagefläche mit zumindest einem an einem Grundkörper angeordneten Sauganschluss zum Verbinden mit einer Unterdruckvorrichtung und zum Aufspannen des Werkstücks auf einer Spannplatte mittels Unterdruck. In der Spannplatte sind offene Ansaugnuten vorgesehen, die separat mit einem Unterdruck und getrennt zur benachbarten Ansaugnut beaufschlagt werden können.

Aus der US 2010/0013169 A1 ist eine Vakuumspannvorrichtung zum Aufspannen von Wafern bekannt. Diese Vakuumspannvorrichtung umfasst eine Auflagefläche aus mehreren konzentrisch angeordneten Nuten, die mit Vakuum beaufschlagbar sind. Diese Nuten sind physikalisch voneinander getrennt angesteuert. Des Weiteren sind drei über den Umfang verteilt angeordnete Anhebestifte vorgesehen, um den Wafer gegenüber der Auflagefläche abzuheben.

Aus der DE 20 2013 102 800 U1 ist eine Vakuumspannvorrichtung bekannt, welche eine Auflage- oder Spannfläche zum Auflegen und Spannen eines Werkstücks mittels Unterdruck umfasst. Eine die Auflage-und Spannfläche aufweisende Spannplatte wird von einem Grundkörper aufgenommen, welcher einen Sauganschluss zum Verbinden mit einer Unterdruckvorrichtung zum Anlegen des Unterdrucks in den Ansaugöffnungen umfasst. Solche Vakuumspannvorrichtungen weisen den Nachteil auf, dass mehrere parallel zueinander ausgerichtete Ansaugöffnungen gemeinsam mit einer Unterdruckleitung mit Unterdruck beaufschlagt werden, wodurch nach der Aufnahme und dem Spannen von kleineren Werkstücken eine erhöhte Leistung der Unterdruckeinrichtung erforderlich ist.

Aus einer Pressemitteilung der Firma Horst Witte Gerätebau Barskamp KG in 21354 Bleckede aus dem Jahr 2011 ist eine Vakuumspannvorrichtung zur Prüfung von Wafern bekannt. Diese Vakuumspannvorrichtung weist eine Spannfläche aus einem mikroporösen Material auf. Durch diese Mikrostruktur werden sehr dünne Werkstücke plan- und beschädigungsfrei fixiert. Die Spannfläche ist in drei schaltbare Spannbereiche für Wafer unterschiedlicher Größe unterteilt. Diese aus einem mikroporösen Material bestehende Spannplatte für eine Vakuumspannvorrichtung weist jedoch den Nachteil auf, dass diese in der Handhabung sehr empfindlich sind und beim Zusetzen oder Versetzen der Oberfläche die Spannfunktion beeinträchtigt wird. Darüber hinaus kann diese nur bedingt eingesetzt werden. Zudem ist durch die mikroporöse Oberfläche der Spannfläche auch eine hohe Unterdruckleistung erforderlich, um die Werkstücke auf der Spannfläche zu fixieren, wenn diese das ausgewählte Segment nicht vollständig abdecken.

Der Erfindung liegt die Aufgabe zugrunde, eine Vakuumspannvorrichtung zum Aufspannen von Werkstücken, insbesondere Wafern, vorzuschlagen, durch welche ein einfaches und ebenes Aufspannen der Werkstücke auf einer Auflagefläche einer Spannplatte ermöglicht ist. Des Weiteren liegt der Erfindung die Aufgabe zugrunde, eine Vakuumspannvorrichtung für eine Messvorrichtung zum Prüfen von Werkstücken sowie ein Verfahren zum Prüfen dieser Werkstücke mittels einer Röntgenfluoreszenzstrahlung vorzuschlagen.

Diese Aufgabe wird durch eine Vakuumspannvorrichtung gelöst, bei der jede Ansaugnut in der Auflagefläche der Spannplatte mit zumindest einem separaten Unterdruck getrennt zur benachbarten Ansaugnut selektiv mittels zumindest einem Steuerventil durch eine Steuerung zum Anlegen des Unterdrucks in der jeweiligen Ansaugnut angesteuert ist. Dadurch erfolgt in Abhängigkeit der Größe des aufzuspannenden Werkstückes eine entsprechende Ansteuerung der jeweiligen durch das Werkstück überdeckten Ansaugnut oder den überdeckten Ansaugnuten, wodurch ein hoher Wirkungsgrad beziehungsweise eine verringerte Leistung einer Unterdruckvorrichtung erforderlich werden, um ein sicheres Aufspannen des Werkstücks zu ermöglichen.

Bevorzugt weist die Auflagefläche mehrere konzentrische Ansaugnuten mit zumindest einer Ansaugöffnung auf, an welche die Unterdruckleitung angeschlossen ist oder welche mit einem Arbeitskanal in Verbindung steht. Durch die kreisförmig ausgebildeten Ansaugnuten ist insbesondere bei Wafern, welche eine kreisrunde Kontur aufweisen, nahe dem äußeren Randbereich der Wafer eine entsprechend an die Größe angepasst Ansaugnut vorgesehen. Dies ermöglicht ein sicheres Aufspannen. Weitere Ansaugnuten, die im Durchmesser größer sind, brauchen dabei nicht mit Unterdruck beaufschlagt werden. Dadurch kann eine Energieeinsparung erzielt werden.

Die Vakuumspannvorrichtung kann für die Prüfung der Werkstücke, insbesondere Wafern, mittels einer Röntgenfluoreszenzstrahlung bevorzugt eine Grundplatte aus einem Material aufweisen, bei der die Ordnungszahl so gewählt ist, dass bei einer auf das Werkstück gerichtete Primärstrahlung eines Röntgenfluoreszenzmessgeräts eine geringe Streustrahlung erzeugt und die Fluoreszenzstrahlung von der Energie so niedrig ist, dass diese im Material des Prüfgegenstandes absorbiert wird. Dabei ist vorteilhafterweise eine nahezu vollständige oder vollständige Absorption vorgesehen.

Alternativ kann die Grundplatte aus einem Material ausgewählt werden, bei dem die Ordnungszahl so gewählt ist, dass die auf das Werkstück gerichtete primäre Röntgenstrahlung eine Fluoreszenzstrahlung erzeugt, bei der in einem Bereich von 20 % bis 80 % der Fluoreszenzstrahlung im Material des zu prüfenden Werkstücks absorbiert wird. Dadurch kann die nicht absorbierte Fluoreszenzstrahlung zur Auswertung bei der Erfassung der Messsignale durch einen Detektor verwendet werden.

Die Vakuumspannvorrichtung sieht vor, dass in der Grundplatte zumindest drei Anhebestifte vorgesehen sind, welche aus einer eingefahrenen Position in oder unterhalb der Auflagefläche der Spannplatte in eine ausgefahrene Position verfahrbar sind. Dies ermöglicht beispielsweise ein Aufsetzen des Werkstücks zu Beginn des Prüfvorganges auf die Anhebestifte, insbesondere durch eine Handhabungseinrichtung. Darauffolgend kann nach dem Herausführen der Handhabungseinrichtung aus dem Bereich der Anhebestifte das Werkstück mittels den Anhebestiften auf die Auflagefläche der Spannplatte sanft aufgesetzt und abgelegt werden, um anschließend dieses Werkstück zu spannen. Ebenso kann nach der Prüfung ein sanftes Anheben des Werkstücks von der Auflagefläche durch die Anhebestifte erfolgen, um darauffolgend eine manuelle Entnahme oder eine automatisierte Entnahme zu ermöglichen.

Die Anhebestifte weisen eine saugnapfähnliche Auflagefläche oder ein Aufnahmeelement mit einer zentralen Bohrung auf, die zur Erzeugung einer Haltekraft mittels Unterdruck mit einer Unterdruckleitung oder einem Saugkanal verbunden ist. Dieses Aufnahmeelement ist bevorzugt aus einem Elastomer ausgebildet, um ein Verkratzen des Werkstücks einerseits zu vermeiden und andererseits beim Anlegen eines Unterdrucks einen schnellen Aufbau eines Vakuums zur Fixierung des Werkstücks auf den Anhebestiften zu ermöglichen.

Die Anhebestifte sind bevorzugt mit einem in dem Grundkörper angeordneten verfahrbaren Schlitten in die eingefahrene und die ausgefahrene Position überführbar, wobei ein Arbeitszylinder, insbesondere ein Pneumatikzylinder, die Verfahrbewegung des Schlittens ansteuert. Dadurch kann eine flachbauende Vakuumspannvorrichtung geschaffen werden, da die Verfahrbewegung des Schlittens in einer XY-Ebene erfolgt, wohingegen die Ausfahrbewegung der Anhebestifte in einer senkrechten Achse, insbesondere einer Z-Achse, vorgesehen ist. Zudem kann die Unterdruckvorrichtung gleichzeitig auch zur Ansteuerung des Arbeitszylinders dienen.

Der verfahrbare Schlitten weist vorteilhafterweise schräglaufende Steuerflächen auf, entlang denen zumindest ein Steuerungselement, insbesondere eine Nocke oder ein Gleit- oder Walzlagerelement, geführt ist, die an dem Anhebestift befestigt ist und diesen verfährt. Dadurch kann die Verschiebebewegung des Schlittens direkt in eine Anhebebewegung der Anhebestifte übertragen werden.

Des Weiteren ist der Anhebestift bevorzugt entlang einer Führungshülse verschiebbar geführt, welche mit einer Unterdruckleitung oder dem Saugkanal im Grundkörper verbunden ist. Dadurch ist ein teleskopartiger Aufbau für den Anhebestift gegeben, wodurch des Weiteren ein flacher Aufbau der Vakuumspannvorrichtung erzielt werden kann. Die Führungshülse ist vorzugsweise fest am Grundkörper fixiert, und deren innere Bohrung mündet in dem Saugkanal.

Der verfahrbare Schlitten ist bevorzugt in dem Grundkörper zwischen der auf dem Grundkörper aufliegenden Spannplatte und einer an der Unterseite des Grundkörpers vorgesehenen Unterplatte positioniert. Dieser Schlitten kann zwischen der Spannplatte und der Unterplatte gleitend oder mittels Rollen oder Kugeln geführt sein. Alternativ kann der Schlitten entlang von Führungselementen verfahrbar aufgenommen sein, die im Grundkörper befestigt sind.

Der verfahrbare Schlitten ist bevorzugt in dem Grundkörper in einem Aufnahmeraum vorgesehen, an welchem an zwei einander gegenüberliegenden Endbereichen Sensorelemente vorgesehen sind, welche die eingefahrene oder ausgefahrene Position der Anhebestifte in Abhängigkeit der Position des Schlittens in dem Aufnahmeraum erfassen. Dadurch ist eine Überwachung einer automatisierten Ansteuerung einer solchen Vakuumspannvorrichtung ermöglicht.

Des Weiteren sind in dem Grundkörper bevorzugt mehrere Anschlagstifte vorgesehen, die aus einer eingefahrenen Position in oder unterhalb der Auflagefläche der Spannplatte in eine ausgefahrene Anschlagposition verfahrbar sind. Diese Anschlagstifte werden insbesondere bei einer manuellen Bestückung der Vakuumspannvorrichtung mit einem Werkstück, insbesondere einem Wafer, eingesetzt. Sofern diese nicht benötigt werden, wie dies insbesondere bei einer automatisierten Bestückung der Fall ist, können diese in oder unterhalb der Auflagefläche der Spannplatte positioniert sein.

Der oder die Anschlagstifte werden bevorzugt zum Überführen in die ausgefahrene Anschlagposition mit einem Überdruck beaufschlagt. Hierzu ist vorteilhafterweise für den oder die Anschlagstifte jeweils ein Versorgungskanal vorgesehen, in dem der Überdruck angelegt wird. Dadurch lassen sich zwei oder mehrere Anschlagstifte, die für eine aufzuspannende Größe des Werkstücks vorgesehen sind, gleichzeitig ansteuern.

Des Weiteren nehmen die Anschlagstifte durch Entlüften des Versorgungskanals mittels einer an dem Anschlagstift angreifenden Rückstellfeder selbständig die eingefahrene Position ein. Dadurch ist sichergestellt, dass auch bei einer gegebenenfalls erfolgenden Störung bei der Druckversorgung die Anschlagstifte nicht gegenüber der Aufspannfläche der Spannplatte hervorstehen und somit die Vakuumspannvorrichtung weiterhin zu verwenden ist.

Jeder Ansaugnut sind bevorzugt wenigstens zwei Anschlagstifte zugeordnet, die mit einem gemeinsamen Versorgungskanal mit Überdruck ansteuerbar sind, wobei diese zumindest zwei Anschlagstifte jeweils radial außerhalb der jeweiligen Ansaugnut angeordnet sind, die zumindest für die entsprechende Größe des aufzunehmenden Werkstücks angesteuert wird. Dadurch werden jeder Größe der Ansaugnut die entsprechenden Anschlagstifte zugeordnet, so dass diese Vakuumspannvorrichtung für mehrere Größen von Werkstücken einsetzbar ist. Beispielsweise können Wafer mit einem Durchmesser von 4", 6", 8", 10" und/oder 12" (Zoll) aufgespannt und geprüft werden.

Eine weitere vorteilhafte Ausgestaltung der Vakuumspannvorrichtung sieht vor, dass außerhalb einer kleinsten oder einer ersten Ansaugnut wenigstens drei Anhebestifte vorgesehen und in Umfangsrichtung gesehen versetzt zu diesen Anhebestiften zumindest zwei Anschlagstifte der zu kleinsten oder ersten Ansaugnut zugeordnet sind. Dadurch werden alle für die Vakuumspannvorrichtung aufzunehmenden Größen von Werkstücken gleichermaßen durch die Anhebestifte aufgenommen, auf die Auflagefläche abgesenkt und/oder wieder angehoben und ebenso eine manuelle Bestückung durch das Positionieren des Werkstücks an den jeweiligen Anschlagstiften ermöglicht.

Eine weitere bevorzugte Ausgestaltung der Vakuumspannvorrichtung sieht vor, dass zwischen jeweils zwei benachbarten weiteren Ansaugnuten wenigstens zwei Anschlagstifte vorgesehen sind. Die in der jeweiligen Ansaugnut angeordneten Anschlagstifte sind vorzugsweise in radialer Richtung entlang eine Geraden ausgerichtet. Dadurch können gleiche Handhabungsbedingungen für unterschiedliche Größen von aufzunehmenden Werkstücken auf der Spannplatte der Vakuumspannvorrichtung gegeben sein.

Der Grundkörper der Vakuumspannvorrichtung weist bevorzugt auf einer zur Spannplatte weisenden Seite zu den Ansaugnuten komplementär verlaufende Arbeitskanäle auf, welche mit zumindest einer Ansaugöffnung der jeweiligen Ausgangsnut in der Auflagefläche zur Spannplatte in Verbindung stehen und vorzugsweise jeder Arbeitskanal separat mit Vakuum durch ein Steuerventil angesteuert ist. Dadurch werden eine flachbauende Anordnung und eine selektive Ansteuerung der jeweiligen Ansaugnut erzielt.

In einer Unterplatte der Vakuumspannvorrichtung ist bevorzugt jeweils ein Versorgungskanal vorgesehen, der mit jeweils einem Zuführkanal in der Grundplatte verbunden ist, wobei der Versorgungskanal zumindest zwei Anhebestifte gleichzeitig mit Überdruck beaufschlagt. Dies ermöglicht ebenso eine kompakte Anordnung der Vakuumspannvorrichtung mit einer geringen Aufbauhöhe.

Die der Erfindung zugrundeliegende Aufgabe wird des Weiteren durch eine Messvorrichtung zum Prüfen von Werkstücken, insbesondere Wafern, mit einer Röntgenfluoreszenzstrahlung gelöst, bei welchen auf einem verfahrbaren Messtisch der Messvorrichtung eine Vakuumspannvorrichtung nach einem der vorbeschriebenen Ausführungsformen vorgesehen ist. Durch die geringe Aufbauhöhe kann eine solche Vakuumspannvorrichtung bei bisherigen Röntgenfluoreszenz-Messvorrichtungen eingesetzt werden. Des Weiteren kann durch die Auswahl des Materials für die Grundplatte eine einfache Anpassung an verschiedene Messaufgaben und Materialien der zu prüfenden Werkstücke ermöglicht sein. Dabei können entsprechende Vakuumspannvorrichtungen ausgetauscht werden oder die Spannplatten mit unterschiedlichem Material austauschbar an dem Grundkörper der Vakuumspannvorrichtung befestigbar sein.

Die der Erfindung zugrundeliegende Aufgabe wird des Weiteren durch ein Verfahren zum Prüfen eines Werkstücks, insbesondere eines Wafers, mit einer Röntgenfluoreszenzstrahlung gelöst, bei welchem insbesondere folgende Schritte vorgesehen sind:

Die Vakuumspannvorrichtung wird vor dem Bestücken mit einem Werkstück aktiviert. Dabei werden Anhebestifte gegenüber der Auflagefläche der Spannplatte in eine ausgefahrene Position übergeführt. Anschließend kann das zu prüfende Werkstück mit einer Handhabungseinrichtung auf die Anhebestifte aufgelegt und ein Unterdruck an den Anhebestiften angelegt werden, um das zu prüfende Werkstück zu den Anhebestiften zu fixieren. Darauffolgend kann die Handhabungseinrichtung aus der Messvorrichtung herausgeführt werden. Die Anhebestifte werden mit einer Verfahrbewegung angesteuert, so dass diese in eine eingefahrene Position übergeführt und das Werkstück auf die Auflagefläche aufgelegt wird. Danach wird entsprechend der Größe des Werkstücks zumindest die äußerste Ansaugnut mit Unterdruck beaufschlagt und das Werkstück auf die Auflagefläche aufgespannt. Nachdem die Prüfung des Werkstücks mittels Röntgenfluoreszenzstrahlung durchgeführt wurde, wird der Unterdruck von der zumindest einen damit beaufschlagten Ansaugnut abgeschalten, und die Anhebestifte werden in die ausgefahrene Position übergeführt. Darauffolgend wird das Werkstück durch die Handhabungseinrichtung ergriffen und der Unterdruck an den Anhebestiften abgeschalten. Das Werkstück kann dann mittels der Handhabungseinrichtung aus der Messvorrichtung entnommen werden.

Bevorzugt kann der an den Anhebestiften angelegte Unterdruck auch während dem Aufspannen des Werkstücks auf der Auflagefläche der Spannplatte aufrechterhalten bleiben. Alternativ kann diese auch zum Zeitpunkt des Aufspannens des Werkstücks auf der Auflagefläche abgeschaltet werden.

Die Erfindung sowie weitere vorteilhafte Ausführungsformen und Weiterbildungen derselben werden im Folgenden anhand der in den Zeichnungen dargestellten Beispiele näher beschrieben und erläutert. Die der Beschreibung und den Zeichnungen zu entnehmenden Merkmale können einzeln für sich oder zu mehreren in beliebiger Kombination erfindungsgemäß angewandt werden. Es zeigen:
Figur 1 eine perspektivische Ansicht einer Röntgenfluoreszenzmessvorrichtung mit einer Vakuumspannvorrichtung,
Figur 2 eine schematische Ansicht von oben auf die Vakuumspannvorrichtung gemäß Figur 1,
Figur 3 eine schematische Schnittansicht der Vakuumspannvorrichtung entlang der Linie II-II in Figur 2,
Figur 4 eine schematisch vergrößerte Ansicht des Details B in Figur 3,
Figur 5 eine schematisch vergrößerte Ansicht des Details C in Figur 3,
Figur 6 eine perspektivische Ansicht der Vakuumspannvorrichtung mit abgehobener Spannplatte,
Figur 7 eine schematische Ansicht von oben auf einen Grundkörper der Vakuumspannvorrichtung,
Figur 8 eine schematische Ansicht von unten auf den Grundkörper der Vakuumspannvorrichtung mit abgehobener Unterplatte,
Figur 9 eine perspektivische Detailansicht des Details D in Figur 3,
Figur 10 eine schematisch vergrößerte Ansicht eines Anhebestiftes gemäß Detail D in Figur 3,
Figur 11 eine schematische Schnittansicht entlang der Linie XI-XI in Figur 9,
Figur 12 eine schematische Ansicht von unten auf eine Unterplatte des Grundkörpers der Vakuumspannvorrichtung mit abgehobener Abdeckplatte,
Figur 13 eine schematische Schnittansicht entlang der Linie XII-XII in Figur 12,
Figur 14 eine perspektivische Ansicht der Vakuumspannvorrichtung in einer Arbeitsposition während einer automatisierten Bestückung mit einem Werkstück,
Figur 15 eine perspektivische Ansicht auf eine Vakuumspannvorrichtung mit einem aufgenommenen Werkstück,
Figur 16 eine perspektivische Ansicht einer Arbeitsposition der Vakuumspannvorrichtung für eine manuelle Bestückung eines Werkstücks, und
Figur 17 eine perspektivische Ansicht eines manuell bestückten Werkstücks auf der Vakuumspannvorrichtung.

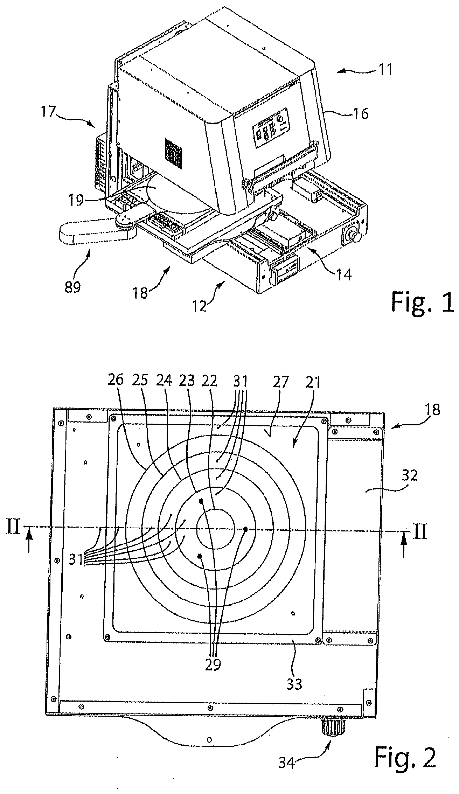

In Figur 1 ist perspektivisch eine Messvorrichtung 11 zur Durchführung einer Messung mittels einer Röntgenfluoreszenzstrahlung dargestellt. Diese Messvorrichtung 11 umfasst einen Messtisch 12, der beispielsweise mittels eines Linearachsensystems 14 in einer XY-Ebene verfahrbar ist. Innerhalb eines Gehäuses 16 der Messvorrichtung 11 sind nicht näher dargestellt eine Strahlungsquelle zur Erzeugung einer Primärstrahlung sowie ein oder mehrere Umlenkelemente zum Führen der primären Röntgenstrahlung auf ein auf dem Messtisch 12 aufliegendes Werkstück 19. Des Weiteren umfasst die Messvorrichtung 11 im Gehäuse 16 einen Detektor, durch welchen die von dem Werkstück 19 limitierte Sekundärstrahlung erfasst wird. Dieser Detektor ist mit einer Steuerungseinrichtung 17 verbunden, um die erfassten Messsignale auszuwerten und vorteilhafterweise über ein Display anzuzeigen.

Eine erfindungsgemäße Vakuumspannvorrichtung 18, welche in den nachfolgenden Figuren näher beschrieben ist, dient zur Aufnahme und zum Aufspannen von Werkstücken 19, insbesondere Wafern. Diese Vakuumspannvorrichtung 18 kann auf den Messtisch 12 der Messvorrichtung 11 montiert oder befestigt sein, um das Werkstück 19, insbesondere Wafer, zur Prüfung, beispielsweise mittels Röntgenfluoreszenzstrahlung, zu fixieren. Dieses Werkstück 19 kann beispielsweise mit einer Handhabungseinrichtung 89 auf der Vakuumspannvorrichtung 18 aufgelegt werden.

In Figur 2 ist eine schematische Ansicht von oben auf die Vakuumspannvorrichtung 18 dargestellt. Diese umfasst eine Spannplatte 21 mit einer Auflagefläche 27, welche mehrere Ansaugnuten 22, 23, 24, 25, 26 umfasst. Diese Ansaugnuten 22 bis 26 sind durch eine kreisrunde Vertiefung ausgebildet, welche in die Auflagefläche 27 der Spannplatte 21 eingebracht sind. Bevorzugt sind die Ansaugnuten 22 bis 26 konzentrisch zueinander angeordnet. Die Anzahl der Ansaugnuten 22 bis 26 kann in Abhängigkeit der Größe der Spannplatte 21 und/oder der aufzunehmenden Werkstücke 19 für die Messaufgabe angepasst sein.

Des Weiteren umfasst die Vakuumspannvorrichtung 18 Anhebestifte 29, beispielsweise drei Anhebestifte 29. Diese sind bevorzugt zwischen der ersten Ansaugnut 22 und der zweiten Ansaugnut 23 angeordnet. Insbesondere sind diese gleichmäßig über den Umfang verteilt angeordnet. Die Anhebestifte 29 sind bevorzugt aus Edelmetall.

Die Vakuumspannvorrichtung 18 kann des Weiteren Anschlagstifte 31 aufweisen, wobei jeder Ansaugnut 22 bis 26 wenigstens zwei Anschlagstifte 31 zugeordnet sein können, um ein Positionieren und Ausrichten des Werkstücks 19 zu erzielen. Die Anschlagstifte 31 sind beispielsweise versetzt zueinander, insbesondere in einem Winkel von 90° versetzt zueinander, angeordnet. Für zwei kleinere Größen von aufzunehmenden Werkstücken 19 sind der ersten Ansaugnut 22 und der zweiten Ansaugnut 22 jeweils beispielsweise drei Anschlagstifte 31 zugeordnet, wobei zwei Anschlagstifte 31 auf einer gemeinsamen Geraden liegen, um eine zusätzliche Ausrichtung an einer Anschlagfläche des Werkstücks 19 zu erzielen.

Die Vakuumspannvorrichtung 18 umfasst einen Grundkörper 33, der die Spannplatte 21 aufnimmt. Die Spannfläche 21 kann fest an dem Grundkörper vorgesehen sein, beispielsweise durch eine Verklebung, Verschraubung oder Vernietung. Alternativ kann die Spannplatte 21 auch auswechselbar an dem Grundkörper 33 vorgesehen sein. Hierzu sind bevorzugt lösbare Befestigungselemente vorgesehen. Die Spannplatte 21 kann aus verschiedenen Materialien bestehen und entsprechend der Messaufgabe ausgewählt werden.

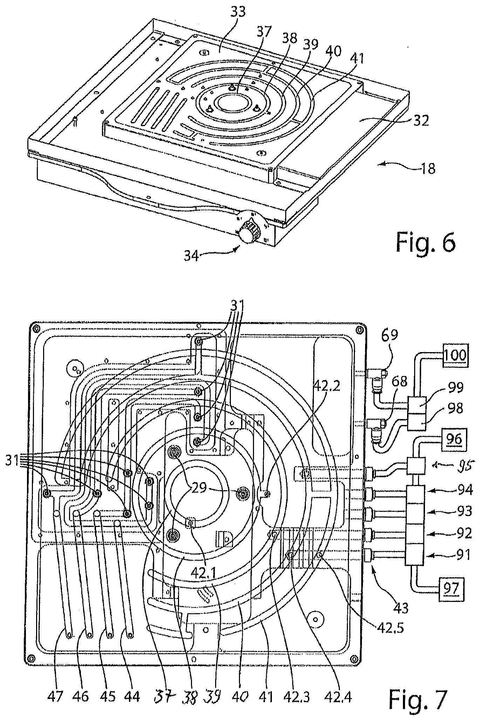

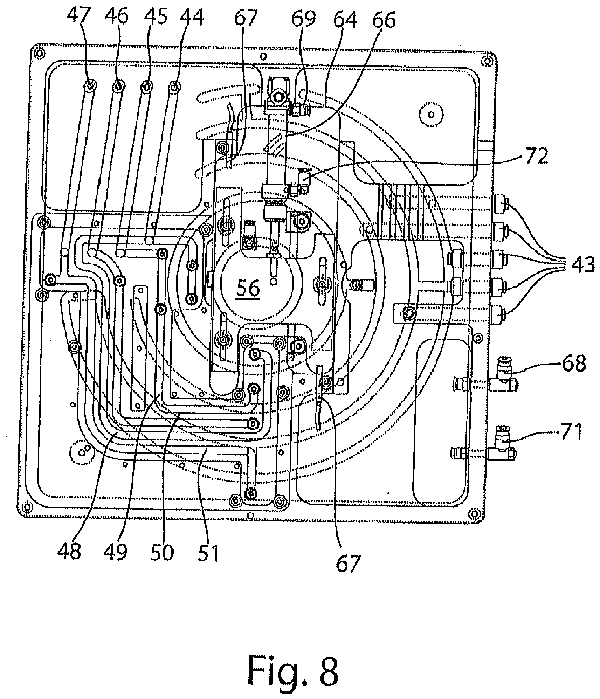

An einer Stirnseite der Vakuumspannvorrichtung 18 ist ein Stellelement 34 vorgesehen, welches ein nicht näher dargestelltes Mehrstellungsventil ansteuert, um die einzelnen Anschlagstifte 31 entsprechend der Größe der aufzuspannenden Werkstücke 19 entsprechend zu betätigen. Dies wird nachfolgend noch näher beschrieben. Unter einer Abdeckung 32 sind mehrere Anschlüsse 43 vorgesehen, die nachfolgend noch anhand der Figuren 7 und 8 erörtert werden.

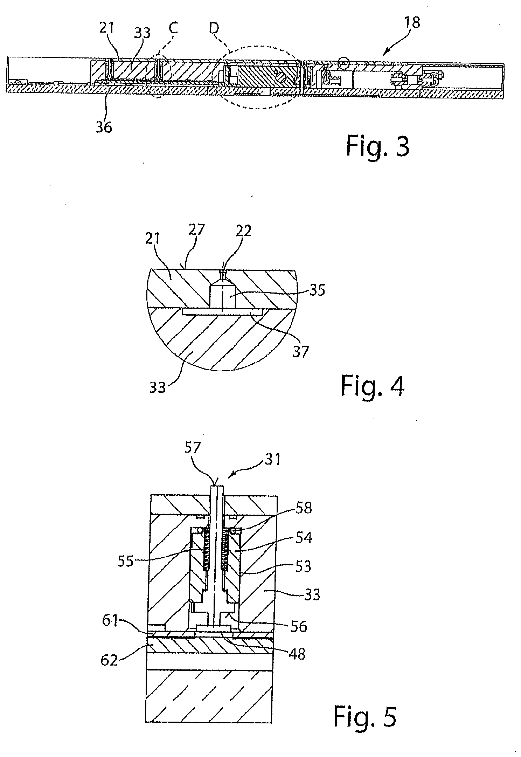

In Figur 3 ist eine schematische Schnittansicht entlang der Linie II-II in Figur 2 dargestellt. Daraus geht der prinzipielle Aufbau der Vakuumspannvorrichtung 18 hervor. Die Spannplatte 21 liegt auf einer Oberseite des Grundkörpers 33 auf. An einer Unterseite des Grundkörpers 33 ist eine Unterplatte 36 befestigt. Zwischen der Spannplatte 21 und dem Grundkörper 33 befinden sich Arbeitskanäle 37, 38, 39, 40, 41 (Figur 6) zur Ansteuerung der Ansaugnuten 22 bis 26. Diese Arbeitskanäle 37 bis 41 sind beispielhaft im Querschnitt vergrößert in Figur 4 dargestellt und in einer perspektivischen Ansicht von oben in Figur 6, wobei die Figur 6 eine perspektivische Ansicht des Grundkörpers 33 bei einer abgenommenen Spannplatte 21 darstellt. Die Arbeitskanäle 37 bis 41 sind bevorzugt in die Oberfläche des Grundkörpers 33 eingebracht. Alternativ können diese auch in die Unterseite der Spannplatte 21 eingebracht sein. An der Oberseite der Spannplatte 21 sind die Ansaugnuten 22 bis 26 vorgesehen. Diese sind beispielsweise rechteckig ausgebildet und erstrecken sich von der Auflagefläche 27 nur geringfügig in Richtung Grundkörper 33. Zum Verbinden der Ansaugnuten 22 bis 26 mit den Arbeitskanälen 37 bis 41 ist zumindest zwischen jedem Arbeitskanal 37 bis 41 und jeden dem Arbeitskanal 37 bis 41 zugeordneten Ansaugnuten 22 bis 26 jeweils zumindest eine Ansaugöffnung 35 vorgesehen. Dieses Detail B gemäß Figur 3 ist in Figur 4 vergrößert dargestellt.

Das Detail C in Figur 3 ist schematisch vergrößert in Figur 5 dargestellt, wobei die Anschlagstifte 31 in einer eingefahrenen Position in Figur 3 und in einer ausgefahrenen Position vergrößert in Figur 5 dargestellt sind. Der Anschlagstift 31 ist in einer Aufnahme 53 im Grundkörper 33 aufgenommen, wobei der Anschlagstift 31 in einen Kolben 54 eingesetzt ist. Der Kolben 54 ist verschiebbar in der Aufnahme 53 geführt. Zwischen dem Anschlagstift 31 und dem Kolben 51 ist eine Rückstellfeder 55 angeordnet. Diese stellt sicher, dass bei einer Nichtbeaufschlagung einer Druckfläche 56 am Anschlagstift 31 mit Überdruck der Anschlagstift 31 in eine eingefahrene Position übergeführt ist. Dabei liegt eine Stirnfläche 57 des Anschlagstiftes 31 in der Auflagefläche 27 der Spannplatte 21 oder unterhalb. Zur Erzeugung und Aufrechterhaltung einer Ausfahrbewegung des Anschlussstiftes 31 wird die Aufnahme 54 mit Überdruck beaufschlagt, der an der Druckfläche 56 wirkt. Über eine Dichtung 58 ist ein Ausblasen durch eine Öffnung im Grundkörper 33 und in der Spannplatte 21 verhindert, durch welche sich der Anschlagstift 31 erstreckt. Ein Versorgungskanal 48 für den Überdruck ist zu benachbarten Versorgungskanälen 49, 50, 51 (Figur 7) durch eine Dichtmatte 61 abgedichtet, welche mittels einer Zwischenplatte 62 zum Grundkörper 33 durch Klemmung befestigt ist. Der Anschlagstift 31 ist bevorzugt aus Edelmetall hergestellt.

In Figur 6 ist eine perspektivische Ansicht des Grundkörpers 33 bei abgenommener Spannplatte 21 dargestellt. Daraus sind die Verläufe der einzelnen Arbeitskanäle 37, 38, 39, 40, 41 ersichtlich, welche sich unterhalb den Ansaugnuten 22 bis 26 erstrecken. Durch das Einbringen der Arbeitskanäle 37 bis 41 in die Grundplatte 33 kann ein flacher Aufbau geschaffen werden, um die Ansaugnuten 22 bis 26 mit Unterdruck zu versorgen.

Aus Figur 7 ist zu entnehmen, dass jedem Arbeitskanal 37 bis 41 eine Anschlussbohrung 42, 42.1, 42.2, 42.3, 42.4 und 42.5 zugeordnet ist, welche jeweils zu einem Anschlussstück 43 führt, an welchem jeweils eine Unterdruckleitung anschließbar ist. Alternativ können die Anschlussbohrungen 42.4 und 42.5 zu einem Anschlussstück 43 führen. Jedes dieser Anschlussstücke 43 ist mit einem Steuerventil 91, 92, 93, 94 separat verbunden und wird durch dieses Steuerventil 91 bis 94 separat angesteuert. Zur Ansteuerung dieser Steuerventile 91 bis 94 ist eine Steuerung 96 vorgesehen. Jedes dieser Steuerventile 91 bis 94 wird separat durch die Steuerung 96 angesteuert. Diese Steuerung 96 kann mit der Steuerungseinrichtung 17 in Verbindung stehen. Die Arbeitskanäle 37 bis 41 werden durch eine Unterdruckvorrichtung 97 mit Unterdruck versorgt.

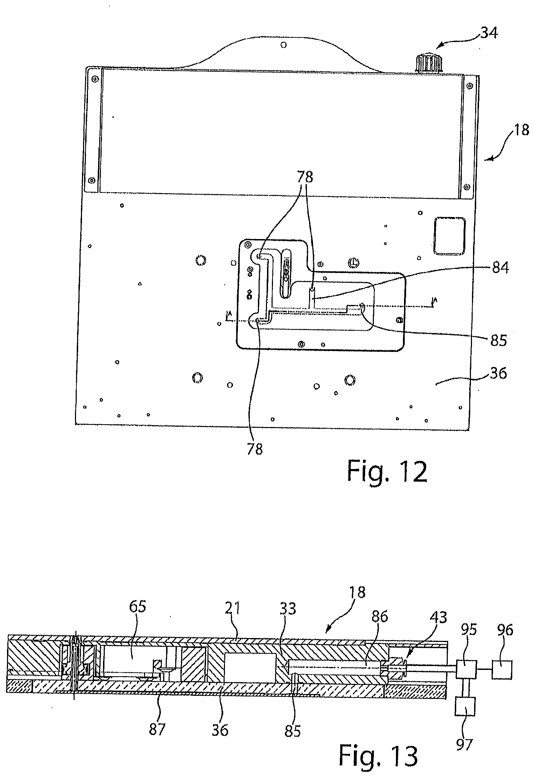

An dem Grundkörper 33 ist des Weiteren ein Anschlussstück 43 vorgesehen, welches mit dem Steuerventil 95 angesteuert wird. Dieses Steuerventil 95 regelt das Anliegen des Unterdrucks an den Anhebestiften 29. In Figur 13 ist dies genauer beschrieben. Dieses Steuerventil 95 wird ebenfalls durch die Steuerung geschalten.

An einer Oberseite des Grundkörpers 33 sind des Weiteren vier Zuführkanäle 44 bis 47 vorgesehen, durch welche jeweils ein Überdruck in einen damit verbundenen Versorgungskanal 48 bis 51 geführt werden kann. Diese Versorgungskanäle 48 bis 51 können durch das Mehrschaltventil angesteuert werden, welches mittels des Bedienelements 34 ausgewählt wird. Diese Versorgungskanäle 48 bis 51 werden mit einer Überdruckvorrichtung mit Überdruck versorgt. Dies kann durch eine separate Überdruckvorrichtung oder auch durch eine entsprechende Ansteuerung der Unterdruckvorrichtung 97 erfolgen.

Jedem Versorgungskanal 48 bis 51 sind zumindest zwei Anschlagstifte 31 zugeordnet. Beispielsweise mündet der Zuführkanal 44 in den Versorgungskanal 48, in welchem insgesamt beispielsweise drei Anschlagstifte 31 angesteuert werden, welche zwischen der ersten Ansaugnut 22 und der zweiten Ansaugnut 23 beziehungsweise dem entsprechenden Arbeitskanal 37, 38 angeordnet sind. Dieser Zuführkanal 44 wird beispielsweise mit Druckluft beaufschlagt, sofern ein Werkstück 19, insbesondere ein Wafer, mit einem Durchmesser von 4" (4 Zoll) aufgelegt und aufgespannt werden soll. Der Zuführkanal 45 wird für ein 6"-Wafer, der Zuführkanal 46 für ein 8"-Wafer und der Zuführkanal 47 für ein 12"-Wafer beaufschlagt.

Der Verlauf der Zuführkanäle 44 bis 47 und Versorgungsleitungen 48 bis 51 wird auch aus der Ansicht des Grundkörpers 33 von unten gemäß Figur 8 deutlich.

Im Bereich der Zuführkanäle 44 bis 47 sind die Arbeitskanäle 39 bis 41 im Grundkörper 33 zwar unterbrochen, jedoch genügt das Anlegen eines Vakuums in diesen Bereichen, um innerhalb den korrespondierenden Ansaugnuten 22 bis 26 jeweils ein ringförmiges Vakuum zu erzielen, wodurch eine plane Auflage des Werkstücks 19 auf die Auflagefläche 27 der Spannplatte 21 gegeben ist.

Aus Figur 7 als auch Figur 8 geht ein Aufnahmeraum 64 im Grundkörper 33 hervor, in welchem ein verfahrbarer Schlitten 65 angeordnet ist, wie dies insbesondere in Figur 8 dargestellt ist. Dieser Schlitten 65 nimmt die drei Anhebestifte 29 auf. Durch eine Verfahrbewegung des Schlittens 65, die durch einen Zylinder 66, insbesondere Pneumatikzylinder, angesteuert wird, werden die Anhebestifte 29 aus einer eingefahrenen Position in eine ausgefahrene Position übergeführt. Zur Ansteuerung des Zylinders 66 ist ein Anschluss 68 mit einem Anschluss 69 am Zylinder 66 verbunden. Zur Ansteuerung einer entgegengesetzten Verfahrbewegung sind die Anschlüsse 71 und 72 miteinander verbunden. Diese Anschlüsse 68, 71 werden jeweils durch ein Steuerventil 98, 99 oder durch ein gemeinsames Steuerventil entsprechend der gewünschten Verfahrbewegung mit der Steuerung 96 angesteuert. Über einer Druckvorrichtung 100 wird der Zylinder 66 mit Überdruck versorgt.

Die Zu- und Abluft des Zylinders 66 wird über die Steuerventile 98, 99 geregelt. Der Zylinder 66 kann eine einstellbare Endlagendämpfung aufweisen. Dadurch kann ein sanftes Anheben und Absenken der Anhebestifte 29 zum Ablegen und Anheben des Werkstücks 19 auf der Auflagefläche 27 der Spannplatte 21 eingestellt werden und ermöglicht sein. Die Anschlüsse 68, 69, durch welche die Steuerventile 98, 99 in der Vakuumvorrichtung 18 verbunden sind, um die Zuluft für den Zylinder 66 zuzuführen, umfassen Drosselrückschlagventile, um zumindest die Abluft zu drosseln.

Zur Lageerkennung der jeweiligen eingefahrenen oder ausgefahrenen Position der Anhebestifte 29 sind Sensorelemente 67 einander gegenüberliegend angeordnet. Diese erfassen die Position des Schlittens 65 im Aufnahmeraum 64 und leiten die Signale an die Steuerung 96 und/oder Steuerungseinrichtung 17 weiter. Aus der Position des Schlittens 65 wird aufgrund der Zwangsführung der Anhebestifte 29 auch die Position der Anhebestifte 29 erfasst.

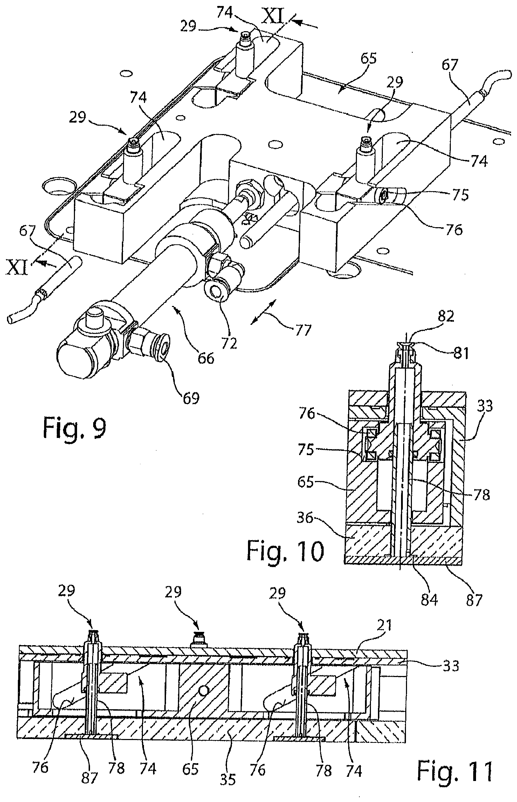

In Figur 9 ist eine perspektivische Ansicht des Schlittens 65 mit den Anhebestiften 29 dargestellt. Figur 10 zeigt eine erste Schnittansicht der Anhebestifte 29. Die Figur 11 zeigt eine weitere Schnittansicht entlang der Linie XI-XI in Figur 9.

Der Schlitten 65 weist bevorzugt eine in etwa H-förmige Gestalt auf, wobei jeweils in einem Schenkel längliche Ausnehmungen 74 vorgesehen sind, innerhalb denen die Anhebestifte 29 verfahrbar sind. Der Anhebe-stift 29 ist mit zumindest einem Steuerelement 75, insbesondere einem Nocken, einem Wälz- oder einem Gleitlager, verbunden, welcher entlang einer schräg verlaufenden Steuerfläche 76 verfahrbar ist. Durch eine Verschiebebewegung des Schlittens 65 in einer XY-Ebene beziehungsweise gemäß Pfeil 77 wird eine senkrecht dazu ausgerichtete Aus- und Einfahrbewegung der Anhebestifte 29 erzeugt. Dabei ist der Anhebestift 29 vertikal verfahrbar entlang einer Führungshülse 78 geführt, so dass diese aus einer eingefahrenen Position in eine in Figur 10 und Figur 11 dargestellte ausgefahrene Position überführbar ist. Alle drei Anhebestifte 29 werden gleichzeitig durch die Verfahrbewegung des Schlittens 65 auf und ab bewegt.

Der Anhebestift 29 weist an seinem oberen Ende ein saugnapfähnliches Aufnahmeelement 81 auf, welches vorzugsweise aus Kunststoff ausgebildet ist. Innerhalb des Aufnahmeelementes 81 ist eine Bohrung 82 vorgesehen, welche mit der Führungshülse 78 fluchtet, so dass ein über die Führungshülse 78 erzeugter Unterdruck auch an dem Aufnahmeelement 81 anliegt. Bei einem aufliegenden Werkstück 19 wird diese zum Auflageelement 81 fixiert. Die Führungshülse 78 und der Anhebestifte 29 sind durch einen gemeinsamen Saugkanal 84 miteinander verbunden. Ein solcher Saugkanal 84 ist in der Ansicht von unten auf die Unterplatte 36 in Figur 12 verdeutlicht. Die dort dargestellten Abzweigungen zeigen, dass an den jeweiligen Enden des Saugkanals 84 eine Verbindung zu der jeweiligen Führungshülse 78 gegeben ist. Über eine Anschlussbohrung 85 und einen Stichkanal 86 wird ein Unterdruck beispielsweise mit der Unterdruckvorrichtung 97 in dem Saugkanal 84 erzeugt. Das Anlegen und Abschalten des Vakuums wird über die Steuerung 96 und das Steuerventil 95 geregelt. Der Arbeitskanal 84 ist bevorzugt in die Unterplatte 36 eingebracht und diese wiederum mit einer separaten Abdeckplatte 87 abdichtend verschlossen.

Unter Bezugnahme auf Figur 1 und die Figuren 14 und 15 wird nachfolgend eine automatisierte Bestückung und Prüfung eines Werkstücks 19 beschrieben.

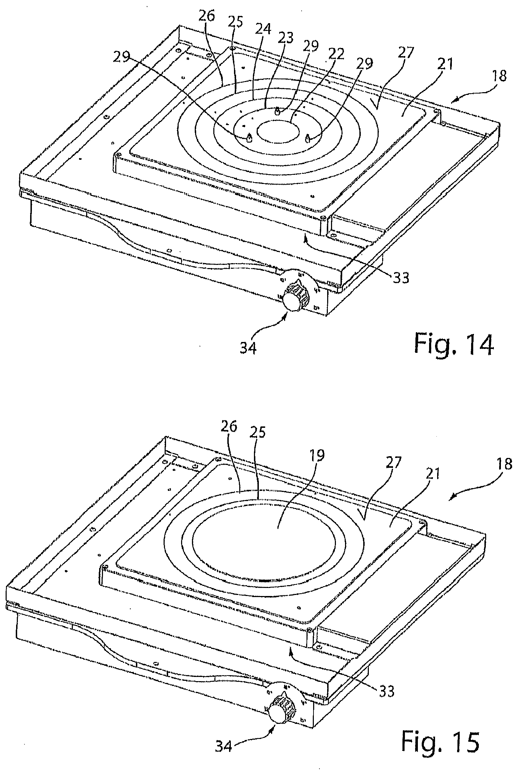

Das Werkstück 19 wird mit einer Handhabungseinrichtung 89 gemäß Figur 1 aus einem nicht näher dargestellten Magazin oder einer Zuführeinrichtung ergriffen und der Messvorrichtung 11 zugeführt. In der Vakuumspannvorrichtung 18 wird der Schlitten 65 durch den Zylinder 66 verfahren, so dass die Anhebestifte 29 aus einer eingefahrenen Position in die in Figur 14 dargestellte ausgefahrene Position übergeführt werden. Diese ausgefahrene Position ist beispielsweise auch in Figur 10 dargestellt. Darauffolgend wird das Werkstück 19 mittels der Handhabungseinrichtung 89 auf den Aufnahmeelementen 81 der Anhebestifte 29 vorzugsweise positionsgenau abgelegt. Darauffolgend wird ein Unterdruck an den Anhebestiften 29 angelegt, so dass das Werkstück 19 aufgrund des Vakuums an den Anhebestiften 29 fixiert ist. Darauffolgend wird die Handhabungseinrichtung 89 aus der Messvorrichtung 11 herausgeführt.

Anschließend wird der Zylinder 66 erneut angesteuert, um den Schlitten 65 in eine weitere Position überzuführen, so dass die Anhebestifte 29 abgesenkt und eingefahren werden. Dies kann durch zumindest eines der Steuerventile 98, 99 erfolgen und durch die Sensorelemente 67 überwacht werden. Das Werkstück 19 kommt sanft zur Anlage auf der Auflagefläche 27 der Spannplatte 21. Vor oder während, gegebenenfalls auch nach dem Absenken wird entsprechend der Größe des Werkstücks 19 die jeweils vorgesehene Ansaugnut 22 bis 26 mit Vakuum beaufschlagt, so dass das Werkstück 19 zur Spannplatte 21 fixiert wird. Das Werkstück 19 gemäß Figur 15 ist beispielsweise ein 8"-Wafer. Durch die Steuerung 96 kann zu diesem Zeitpunkt, wenn das Werkstück 19 auf der Spannplatte 21 fixiert ist, der Unterdruck in den Anhebestiften 29 abgeschalten werden. Dieser kann auch weiterhin aufrechterhalten bleiben. Darauffolgend erfolgt eine Prüfung und/oder Messung des Werkstücks 19 mittels der Röntgenfluoreszenzstrahlung. Nach Abschluss der Prüfung und/oder Messung wird das Vakuum in der entsprechenden Ansaugnut 22 bis 26 gelöst und, sofern das Vakuum in den Anhebestiften 29 abgeschalten wurde, wird dieses vor dem Lösen des Vakuums in der Ansaugnut 22 bis 26 wieder aktiviert und eingeschalten. Daran anschließend folgt eine Verfahrbewegung des Schlittens 65, so dass das Werkstück 19 gegenüber der Auflagefläche 27 wieder angehoben wird. Darauffolgend fährt die Handhabungseinrichtung 89 wieder in die Messvorrichtung 11 ein. Insbesondere untergreift diese das Werkstück 19. Nach dem Abschalten des Vakuums an den Anhebestiften 29 kann das Werkstück 19 aus der Messvorrichtung 11 herausgeführt und gestapelt oder einer weiteren Verarbeitung zugeführt werden.

Es wird zumindest die Ansaugnut 24 mit Vakuum beaufschlagt. Bevorzugt werden auch die kleineren Ansaugnuten 23 und/oder 22 mit Vakuum beaufschlagt. Die Ansaugnuten 25 und 26 werden dabei nicht mit Vakuum beaufschlagt, da diese vom Werkstück 19 nicht überdeckt werden.

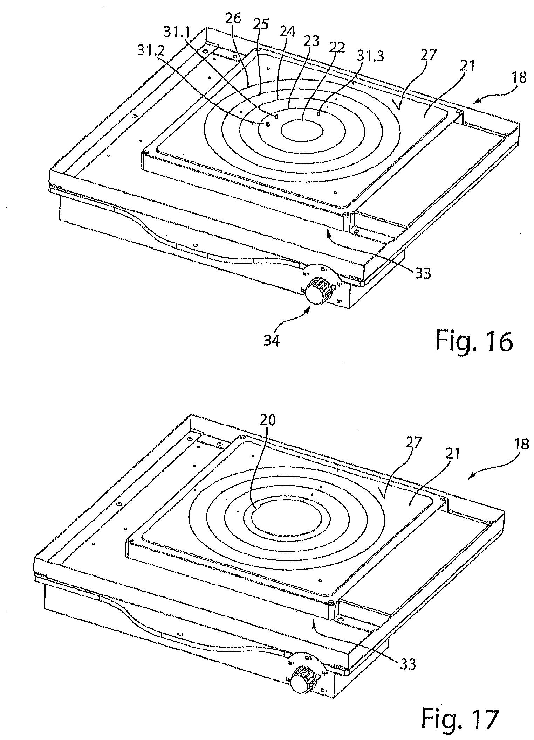

Anhand der Figuren 16 und 17 wird das Positionieren und Auflegen eines Werkstücks von Hand, also ein manueller Betrieb, beschrieben. Für die Prüfung eines Werkstücks 19 gemäß Figur 17, welches beispielsweise ein 4"-Wafer ist, wird zunächst das Bedienelement 34 auf 4" eingestellt. Darauffolgend werden über das Mehrschaltventil der Zuführkanal 44 und der Versorgungskanal 48 mit Druckluft beaufschlagt, wodurch die der Ansaugnut 22 zugeordneten Anschlagstifte 31.1, 31.2, 31.3 ausgefahren werden. Anschließend kann das Werkstück 19 mit seiner Abflachung 20 an den beiden benachbart zugeordneten Anschlagstiften 31.1 und 31.2 angelegt und zum dritten Anschlagstift 31.3 ausgerichtet werden. Zeitgleich mit dem Ausfahren der Anschlagstifte 31 kann ein Vakuum in der Ansaugnut 22 erzeugt werden. Dieses kann aber auch erst nach dem Auflegen des Werkstücks 19 und dessen Ausrichtung zu den Anschlagstiften 31.1, 31.2, 31.3 erfolgen. Zur Entnahme des Werkstücks 19 wird zunächst das Vakuum in der entsprechenden Ansaugnut 22 bis 26, im Ausführungsbeispiel in der Ansaugnut 22, abgeschalten. Anschließend kann das Werkstück 19 manuell entnommen werden. Alternativ kann die Möglichkeit bestehen, dass die Anhebestifte 29 angesteuert werden, um das Werkstück 19 gegenüber der Auflagefläche 27 abzuheben, um eine erleichterte Entnahme zu ermöglichen.

## Patentansprüche

1. Vakuumspannvorrichtung zum Aufspannen von Werkstücken (19), insbesondere Wafern, mit einer eine Auflagefläche (27) aufweisenden Spannplatte (21), mit zumindest einem an einem Grundkörper (33) angeordneten Sauganschluss zum Verbinden mit einer Unterdruckvorrichtung und zum Aufspannen des Werkstücks (19) auf der Spannplatte (21) mittels Unterdruck, welche von dem Grundkörper (33) aufgenommen ist und mit mehreren in der Spannplatte (21) angeordneten und zur Auflagefläche (27) hin offenen Ansaugnuten (22, 23, 24, 25, 26), wobei die Auflagefläche (27) mehrere konzentrische Ansaugnuten (22 bis 26) mit zumindest einer Ansaugöffnung (35) aufweist, an welche eine Unterdruckleitung angeschlossen ist oder welche mit einem Arbeitskanal (37, 38, 39, 40, 41) in Verbindung steht, **dadurch gekennzeichnet, dass** jede Ansaugnut (22 bis 26) mit einem separaten Unterdruck getrennt zur benachbarten Ansaugnut (22 bis 26) selektiv mittels zumindest einem Steuerventil (91, 92, 93, 94) durch eine Steuerung (96) zur Anlage des jeweiligen Unterdrucks in der jeweiligen Ansaugnut (22 bis 26) angesteuert ist, und in dem Grundkörper (33) zumindest drei Anhebestifte (29) vorgesehen sind, welche aus einer eingefahrenen Position in oder unterhalb der Auflagefläche (27) der Spannplatte (21) in eine gegenüber der Auflagefläche (27) ausgefahrenen Position verfahrbar sind, **dadurch gekennzeichnet, dass** die Anhebestifte (29) ein saugnapfähnliches Aufnahmeelement (81) oder ein Auflageelement aufweisen, welches eine zentrale Bohrung (82) umfasst, die mit einem Saugkanal (84) zur Erzeugung einer Haltekraft mittels Unterdruck verbunden ist.

2. Vakuumspannvorrichtung nach Anspruch 1, **dadurch gekennzeichnet, dass** die Spannplatte (21) aus einem Material ausgewählt ist, bei der die Ordnungszahl so gewählt ist, dass bei einem auf das Werkstück (19) gerichteten primären Röntgenstrahlung eine geringe Streustrahlung erzeugt wird und die Fluoreszenzstrahlung von der Energie so gering ist, dass diese im Material des Werkstücks (19) absorbiert wird, oder dass die Spannplatte (21) aus einem Material ausgewählt ist, bei dem die Ordnungszahl so gewählt ist, dass eine auf das Werkstück (19) gerichtete primäre Röntgenstrahlung eine Fluoreszenzstrahlung erzeugt, welche zu 20 % bis 80 % im Material des Werkstücks (19) absorbiert wird.

3. Vakuumspannvorrichtung nach Anspruch 1, **dadurch gekennzeichnet, dass** in dem Grundkörper (33) ein verfahrbarer Schlitten (65) zur Ansteuerung der ein-und ausfahrbaren Position der Anhebestifte (29) vorgesehen ist, der mit einem vorzugsweise pneumatischen Zylinder (66) verfahrbar angesteuert ist und die Anhebestifte (29) gleichzeitig in die eingefahrene Position und in die ausgefahrene Position überführt und vorzugsweise der verfahrbare Schlitten (65) schräg verlaufende Steuerflächen (76) aufweist, entlang denen zumindest ein Steuerelement (75) verfahrbar geführt ist, welches mit dem Anhebestift (29) verbunden ist.

4. Vakuumspannvorrichtung nach einem der Ansprüche 1 oder 3, **dadurch gekennzeichnet, dass** der Anhebestift (29) entlang einer Führungshülse (78) verschiebbar geführt ist, welche mit dem Saugkanal (84) im Grundkörper (33) zur Zeugung eines Unterdrucks verbunden ist.

5. Vakuumspannvorrichtung nach einem der Ansprüche 3 der 4, **dadurch gekennzeichnet, dass** der verfahrbare Schlitten (65) im Grundkörper (33) zwischen der auf dem Grundkörper (33) aufliegenden Spannplatte (21) und einer an der Unterseite des Grundkörpers (33) angeordneten Unterplatte (36) positioniert ist.

6. Vakuumspannvorrichtung nach einem der Ansprüche 3 bis 5, **dadurch gekennzeichnet, dass** der verfahrbare Schlitten (65) in einem Aufnahmeraum (64) des Grundkörpers (33) angeordnet ist und zwei einander gegenüberliegende Sensorelemente (67) dem Aufnahmeraum (64) zugeordnet sind, wodurch die Einnahme der eingefahrenen und ausgefahrenen Position der Anhebestifte (29) in Abhängigkeit der Position des Schlittens (65) im Aufnahmeraum (64) erfassbar ist.

7. Vakuumspannvorrichtung nach einem der vorhergehenden Ansprüche, **dadurch gekennzeichnet, dass** in dem Grundkörper (33) mehrere Anschlagstifte (31) vorgesehen sind, die aus einer eingefahrenen Position in oder unter der Auflagefläche (27) in eine ausgefahrene Position oberhalb der Auflagefläche (27) der Spannplatte (21) verfahrbar sind und vorzugsweise ein oder mehrere Anschlagstifte (31) zum Überführen in eine ausgefahrene Anschlagposition mit zumindest einem Versorgungskanal (48, 49, 50, 51) verbunden sind, der mit Überdruck beaufschlagt ist.

8. Vakuumspannvorrichtung nach Anspruch 7, **dadurch gekennzeichnet, dass** die Anschlagstifte (31) durch Entlüften des jeweiligen mit dem zumindest einen Anschlagstift (31) in Verbindung stehenden Versorgungskanals (48 bis 51) und mittels einer an dem Anschlagstift (31) angreifenden Rückstellfeder (55) selbständig die eingefahrene Position einnehmen.

9. Vakuumspannvorrichtung nach einem der Ansprüche 7 oder 8, **dadurch gekennzeichnet, dass** jeder Ansaugnut (22 bis 26) wenigstens zwei Anschlagstifte (31) zugeordnet sind, die mit einem gemeinsamen Versorgungskanal (48 bis 51) mit Überdruck ansteuerbar sind und vorzugsweise die für eine bestimmte Größe des Werkstückes (19) vorgesehenen Anschlagstifte (31) radial außerhalb der Ansaugnut (22 bis 26) angeordnet sind, welche für dieselbe Größe des Werkstücks (19) vorgesehen ist und vorzugsweise außerhalb der kleinsten oder ersten Ansaugnut (22) wenigstens drei Anhebestifte (29) und versetzt dazu zumindest zwei Anschlagstifte (31) vorgesehen sind.

10. Vakuumspannvorrichtung nach einem der vorhergehenden Ansprüche, **dadurch gekennzeichnet, dass** zwischen jeweils zwei benachbarten zueinander angeordneten Ansaugnuten (22 bis 26) wenigstens zwei Anschlagstifte (31) vorgesehen sind, die vorzugsweise in radialer Richtung hintereinander verlaufend ausgerichtet sind.

11. Vakuumspannvorrichtung nach einem der vorhergehenden Ansprüche, **dadurch gekennzeichnet, dass** auf einer zur Spannplatte (21) weisenden Seite des Grundkörpers (33) zu den Ansaugnuten (22 bis 26) komplementär verlaufende Arbeitskanäle (37 bis 41) vorgesehen sind, welche mit zumindest einer Ansaugöffnung (35) mit den Ansaugnuten (22 bis 26) in der Auflagefläche (27) der Spannplatte (21) in Verbindung stehen und vorzugsweise jeder Arbeitskanal (37 bis 41) separat mit Vakuum durch ein Steuerventil (91 bis 94) angesteuert ist.

12. Vakuumspannvorrichtung nach einem der vorhergehenden Ansprüche, **dadurch gekennzeichnet, dass** in einer Unterplatte (36) Versorgungskanäle (48, 49, 50, 51) vorgesehen sind, die jeweils mit einem Zuführkanal (44, 45, 46, 47) verbunden sind, durch welche die zumindest zwei Anschlagstifte (31), die einer Größe des Werkstücks (19) zugeordnet sind, gleichzeitig mit Überdruck beaufschlagt sind.

13. Messvorrichtung zum Prüfen von Werkstücken (19), insbesondere Wafern, mit einer Röntgenfluoreszenzstrahlung, welche einen verfahrbaren Messtisch (12) zur Aufnahme des zumindest einen Werkstücks (19) aufweist, auf welches eine mittels einer Strahlungsquelle erzeugte primäre Röntgenstrahlung gerichtet ist und die emittierte Sekundärstrahlung mit einem Detektor erfasst und mittels einer Steuerungseinrichtung die durch den Detektor erfassten Messsignale auswertet, **dadurch gekennzeichnet, dass** auf dem verfahrbaren Messtisch (12) eine Vakuumspannvorrichtung (18) nach einem der Ansprüche 1 bis 12 vorgesehen ist.

14. Verfahren zum Prüfen eines Werkstücks (19), insbesondere eines Wafers, mit einer Messvorrichtung (11) nach Anspruch 13,
- bei dem vordem Bestücken der Vakuumspannvorrichtung (18) mit dem Werkstück (19) Anhebestifte (29) gegenüber der Auflagefläche (27) der Spannplatte (21) in eine ausgefahrene Position übergeführt werden,
- bei dem das zu prüfende Werkstück (19) mit einer Handhabungseinrichtung (89) auf die Anhebestifte (29) aufgelegt wird,
- bei der die Anhebestifte (29) mit Unterdruck beaufschlagt und das zu prüfende Werkstück (19) darauf fixiert werden,
- bei dem die Anhebestifte (29) in eine eingefahrene Position übergeführt und das Werkstück (19) auf die Auflagefläche (27) aufgelegt werden,
- bei dem zumindest eine der Größe des Werkstücks (19) entsprechende Ansaugnut (22 bis 26) mit Unterdruck beaufschlagt und das Werkstück (19) auf der Auflagefläche (27) durch Unterdruck fixiert werden,
- bei dem eine Prüfung des Werkstücks (19) mittels Röntgenfluoreszenzstrahlung durchgeführt wird,- bei dem der Unterdruck in der zumindest einen Ansaugnut (22 bis 26) abgeschaltet wird,
- bei dem die Anhebestifte (29) in die ausgefahrene Position übergeführt werden,
- bei dem das Werkstück (19) durch die Halteeinrichtung (89) ergriffen wird und
- bei dem der an den Anhebestiften (29) anliegende Unterdruck abgeschalten und das Werkstück (19) mit der Handhabungseinrichtung (89) aus der Messvorrichtung (11) herausgeführt werden.

15. Verfahren nach Anspruch 14, **dadurch gekennzeichnet, dass** der an den Anhebestiften (29) angelegte Unterdruck während dem Aufspannen des Werkstücks (19) auf der Auflagefläche (27) der Spannplatte (21) aufrechterhalten wird und/oder dass der an den Anhebestiften (29) angelegte Unterdruck nach dem Überführen in eine eingefahrene Position und dem Spannen des Werkstücks (19) durch die zumindest eine mit Unterdruck beaufschlagte Ansaugnut (22 bis 26) abgeschalten und zum Anheben des Werkstücks (19) ein Unterdruck an den Anhebestiften (29) angelegt werden, bevor der Unterdruck an der zumindest einen Ansaugnut (22 bis 26) zum Abheben des Werkstücks (19) abgeschalten wird.
